# EUROPEAN PATENT SPECIFICATION

(11) **EP 0 519 591 B1**
(45) Date of publication and mention of the grant of the patent: **29.01.1997**
(21) Application number: 92303891.3
(22) Date of filing: 30.04.1992
(51) Int. Cl.: G03F 7/033, G03F 7/022, G03F 3/10, G03F 7/11

(54) **Aqueous developable imaging systems**
Mit Wasser entwickelbare Bildaufzeichnungssysteme
Système d'enregistrement d'images, developpables en milieu aqueux

(30) Priority: 17.06.1991 US 716317
(43) Date of publication of application: 23.12.1992
(73) Proprietor: MINNESOTA MINING AND MANUFACTURING COMPANY, St. Paul, Minnesota 55133-3427 (US)
(72) Inventor: Klun, Thomas P., c/o Minnesota Mining and, St. Paul, Minnesota 55133-3427 (US); Heller, Michael B., c/o Minnesota Mining and, St. Paul, Minnesota 55133-3427 (US); Lundquist, Wallace R., c/o Minnesota Mining and, St. Paul, Minnesota 55133-3427 (US)
(74) Representative: Baillie, Iain Cameron

(56) References cited:
- EP-A- 0 165 030
- US-A- 4 310 615
- US-A- 4 666 817

## Description

### Background of the Invention

### Field of the Invention

The present invention relates to negative or positive acting aqueous resist developable photosensitive media, and more particularly to aqueous resist developable color pigmented photosensitive media useful in color proofing.

### Background of the Art

Totally aqueous based (for example, pH 6-11) developable imaging systems are becoming more important as environmental restrictions on solvent containing developers become tighter. In the manufacture of these systems, the use of chlorinated solvents is limited by hazards to the environment and workers. Some imaging systems, particularly color proofing systems, have typically required the use of dispersed pigments, often in chlorinated hydrocarbon treated carrying polymers. The manufacture of some color proofing systems desires the use of aqueous developable, stable pigment dispersions whose milling can be done without chlorinated solvents and which can be formulated with photoimageable materials and be coated out of non-chlorinated solvents to provide an imageable color layer.

The composition of hydroxyl-group-functional polyvinylacetals modified by acid anhydrides is disclosed in U.S. Patents 2,796,413, 3,334,057, 4,426,492, 4,741,985 and 4,777,112. Other polymerizable polyvinylacetals functionalized by anhydrides are described in U.S. Patents 2,861,058, 3,847,614, 4,588,669 and 4,774,161. None of these patents suggest the use of these acid modified polymers as pigment dispersants.

It is known that an acid functionality or latent acid functionality of polyvinylacetals may be polymerized into the backbone of the polymer using acrylic acid, itaconic acid, maleic anhydride and the like (Japanese patents applications JP 58,191,701, JP 58,191,702, JP 55,108,443 and JP 86,050,499). The first two of these references mentions the use of these materials as organic solvent soluble pigment dispersants. Thus, hydroxyl group functional, anhydride modified polyvinylacetals are known and acid group containing polyvinylacetals have been used as pigment dispersants.

U.S. Patent No. 4,631,245 discloses a photosensitive composition comprising a mixture of a diazonium salt polycondensation product and the reaction product of an intramolecular anhydride of an organic polycarboxylic acid with an hydroxyl group containing polymer free of any other group reactive with acid anhydrides. The composition is useful in printing plates and resists. U.S. Patent No. 3,847,614 uses acid functional polymers for dispersion of pigments in photopolymer systems. The binder dispersions are used in diazonium polymer systems. The polymers are formed by copolymerization of acid functional monomers with vinyl acetate, which is in turn followed by hydrolysis of the acetate groups and acetalization with aldehydes.

Commercially available acid containing polyacrylics (i.e., Carboset™ resins, B.F. Goodrich) or styrene maleic anhydride resins in which the anhydrides are reacted with alcohols to produce half acid esters (i.e., Scripset™ resins, Monsanto) do not provide useful dispersing properties for all the variously desirable pigments. They also do not consistently form pigment dispersions that have acceptable stability and particle size when formulated with other imageable materials in non-chlorinated solvents.

The use of polyvinyl acetals as pigment binders in aqueous-developable colour proofing Sheets is described in US-A-4 310 615, US-A-4 666 817 and EP-A-0 165 030.

### Summary of the Invention

Acid-modified polyvinylacetal resins provide stable, pigment dispersions that can be coated free of chlorinated organic solvents in photosensitive aqueous developable imaging systems free of diazonium polymers. Other resins may be mixed with the acid modified resins to modify physical and sensitometric properties.

### Detailed Description of the Invention

Acid-modified polyvinylacetal dispersants are prepared by reacting a polyvinylacetal resin with an organic acid anhydride. The anhydride reacts at the site of hydroxyl groups on the polyvinylacetal resin. A typical reaction scheme for the acid modification of polyvinylacetals useful in the practice of the present invention would be

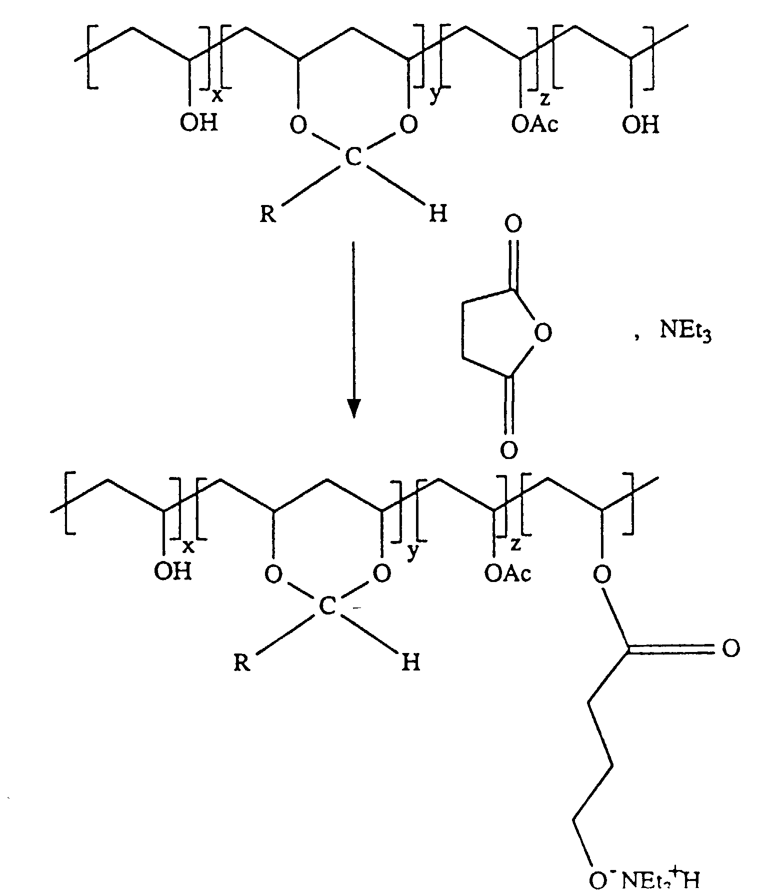

Synthetic procedures for the acid modification of polyvinylacetal resins are known in the art as, for example, U.S. Patents 4,774,161; 4,777,112; 4,741,985; 4,588,669; 4,426,492; and 2,861,058. Typically, the polyvinylacetal polymer containing free hydroxyl groups is dissolved in an aprotic solvent. The dissolved resin is then reacted with a dicarboxylic acid anhydride. This can be done best in the presence of a catalyst. Tertiary amines such as triethylamine are particularly useful. The resulting solutions of acid-modified polyvinylacetal resin may be milled with the pigment selected for dispersing. Any kind of conventional milling may be used. Shot milling, even with its attendant small batch size, metallic contamination and reduced transparency are used in the examples as a matter of convenience. Even with shot milling pigment resin compatibility and dispersion stability can be studied.

It is not necessary to use a homogeneous composition of a single acid-modified polyvinylacetal resin in the practice of the present invention. Blends of different acid modified polyvinylacetal resins and blends with other physically compatible acid modified resins is useful in the practice of the present invention. Acid containing acrylate resins, acid-containing acetate resins, and others may be mixed with the resins of the present invention in amounts up to sixty or seventy percent (60% or 70%) by weight of the acid-modified polyvinylacetal resins.

The proportion of pigment to binder should be between 60 and 500% by weight of pigment to binder. Preferably there is 75 to 300% by weight of pigment to binder. In terms of the total composition, the photosensitive layer(s) of the product generally comprises:

**Table 1A**

| (Negative System) | |
|---|---|
| 7 - 32% | pigment |
| 8 - 20% | binder |
| 30 - 75% | photo oligomer |
| 3 - 19% | sensitizer and initiator |
| 0 - 10% | miscellaneous (particulates, coating aids, etc.) |

**Table 1B**

| (Positive System) | |
|---|---|
| 25 - 45% | pigment |
| 30 - 60% | binder resins |
| 15 - 30% | diazo oxide |
| 0 - 30% | miscellaneous (acid sensitive resins, particulates, coating aids, etc.) |

This positive system preferably does not have the pigment dispersion in the same layer as the diazo oxide and binder resin. The dispersion will be in an adjacent layer with its own binder resin.

The pigment to resin binder ratio must be between 0.6 and 5.0 in order to enable the system to be used for proofing. This is a much higher proportion of pigment than contemplated in the prior art use of acidified resins. It is preferred that the ratio is between 0.8 and 3.0.

The negative acting photosensitive compositions used in making the media of the present invention comprise at least an aqueous dispersible (including aqueous dissolvable) composition of a photoinsolubilizable or photosolubilizable material and a pigment. The photoinsolubilizable material generally increases its molecular weight and/or reacts to remove solubilizing groups when struck by actinic radiation. The material may itself be photosensitive or may be combined with a photosensitive material that acts upon it. Typically the composition will comprise a polymerizable compound (monomer, oligomer, and/or polymer). With many polymerizable materials initiators are desirable or necessary to provide speed or specific radiation sensitivity to the composition. Spectral sensitizers are also desirable for expanding the range of wavelengths which may activate the system. Typical aqueous dissolvable or washable systems would comprise an acrylic functional polymerizable material (or other ethylenically unsaturated polymerizable material such as methacrylics, vinyl groups, or olefinic groups), polymerizable epoxy compounds, etc. These polymerizable materials may have mixtures of polymerizable compounds present, as well as non-polymerizable additives (in addition to the pigment dispersions) such as thickening agents, polymeric binders, surfactants, coating aids, particulate fillers, matting agents, dyes, etc. Two especially important ingredients would generally be photoinitiators for the polymerization reaction and possibly sensitizers for the photoinitiators to assure that the photoinitiators would work at desired wavelengths of irradiation.

Typical photoinitiators for epoxy resin materials include photosensitive aromatic onium salts with complex halogenide counterions such as triphenylsulfonium hexafluoroantimonate, diphenyliodonium tetrafluoroborate diphenylthiophenyl-sulfonium hexafluorophosphate, and the like. Typical photoinitiators for ethylenically unsaturated polymerizable materials are also well known in the art and include photosensitive aromatic onium salts, triazines (e.g., halomethyl-s-triazines), biimidazoles, benzoins, benzophenones, etc.

A vast array of spectral sensitizing dyes are known to be useful for some of these classes of photoinitiators such as cyanine dyes, merocyanine dyes, styryl dyes, azo dyes, etc.

The procedure used for shot milling was as follows: About 560g of 3mm diameter steel shot was placed in a heavy stainless steel shot cup. The solvent, resin and pigment were added to just cover the shot. A typical batch size was 50g of solution at 7.5% solids. The shot cups were clamped four at a time into a Red Devil™ paint conditioner. Samples were shot milled for 20 minutes and strained through a wire mesh tea strainer to separate the shot from the dispersion. Between 50-75% of the dispersion was recovered.

Table 2 shows the results of these shot milling experiments. The stable dispersions were measured for particle size using a Horiba (TM) particle size analyzer. The transparency of the stable polyvinylacetal (Butvar™) dispersions were all greater than 2.00 as measured by an X-Rite (TM) densitometer.

From Table 2 it can be seen that if the level of acid functionality on the Butvar™ resin is too high, the resin will not disperse the pigment as well as other levels. A ratio of about 30:100 for succinic anhydride:Butvar™ seems to be near the desired high limit of acid functionality that allows for very good pigment dispersibility. The useable acid modified Butvar™ resins give about the same particle size (0.3-0.5 µm) as unmodified Butvar™ resin (Comparative examples C1, C2 and C3). Comparative examples C4 through C8 of Scripset™ resins show much larger particles sizes (>1 µm) regardless of what solvent or percent solids is used in milling, or even if dispersing agents (Comparative example C5) are used. Thus the Butvar™ resins modified by succinic anhydride display advantages even over other aqueous developable dispersants.

The Butvar™ B-98 acid modified resin (30 g NEt₃, 30g succinic anhydride, 100g B-98) was also shot milled under the same conditions with Sun Chemical 234-0071 magenta, Sun Chemical 248-0615 cyan, Raven (TM) 760 (N.B. 85977-41) and with a Quindo (TM) RV 6823 pigment (N.B. 85977-42). These all gave stable dispersions.

The acid modified Butvar™ B-98 (30:30:100, NEt₃/SA/B-98 by weight made in MEK) was oven dried at 95°C for approximately 3 hours to provide a solid resin which was two roll milled with a pigment. Here 52.3 g of 95.6% acidified Butvar™ B-98 was milled with 50g Quindo (TM) #6803 (Mobay Chemical) and 15 g of 70:30 n-propanol:water for 100 passes through a 10 mil (0.25 mm) gap. The resultant chips were cut to 10% solids in cyclohexanone overnight on an orbital Shaker and homogenized for 20 minutes on a Silverson (TM) homogenizer to provide a transparent high viscosity dispersion of <0.05 µm.

Having identified some good candidates for color proofing, a number of pigment dispersions were made according to the shot milling procedure described above, using a Fanchon (TM) yellow pigment with Butvar™ resin, acid modified Butvar™ resin, Scripset™ resin and Carboset™ resins. Table 3 describes their makeup. Transparency and particle size analysis were done on each millbase, transparency measurements being made with an X-Rite densitometer with a blue filter over a black light trap and particle size evaluations being made with a Horiba particle size distribution analyzer, the median size value being reported (Table 5).

These millbases were then formulated into coating solutions for evaluation in color proofing constructions. The coating solutions are described in Table 4. Each millbase was used in formulations with SAMP/EPON 1001/0.15 SA NEt₃/0.5 DEA (SAMP/EPON is the adduct of the reaction product of pentaerythritol triacrylate with succinic anhydride and epoxy resin EPON™ 1001 (Shell)). This was further modified so that 0.15 mole fraction of the oligomer's hydroxy groups were modified with succinic anhydride using triethyl amine as a catalyst and that product reacted with diethanolamine (DEA) which would form a Michael addition to 0.5 of the 6 possible acrylate groups of the oligomer, or hydantoin hexaacrylate (HHA, the adduct of pentaerythritol triacrylate with a diepoxide containing a hydantoin heterocyclic having the structure 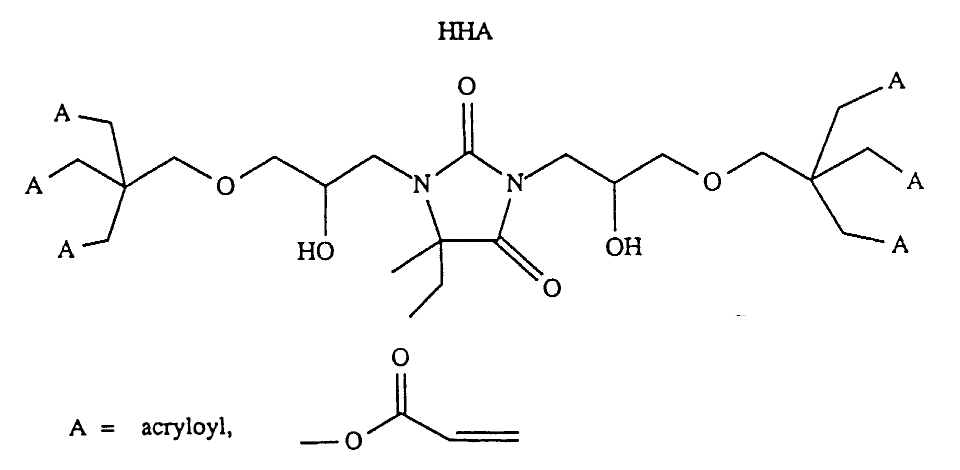 The transparency of the coating solutions was also measured by the procedure described above and found to be acceptable. The color solutions were coated onto polyvinylalcohol coated 2 mil (0.051 mm) polyester for single sheet evaluations and directly onto 2 mil (0.025 mm) polyester for overlay constructions using a #8 Meyer bar at 13.3% solids. The coatings were oven dried for 2 minutes at 100°C. Some coatings were evaluated for an overlay system with no overcoats or adhesives, while others were evaluated in conjunction with adhesives as coatings onto paper base. Two adhesive systems were used on the samples: 1) a B-67 Acryloid™ Resin (Rohm and Haas) in a 10% heptane/VM&P Naphtha solution was overcoated onto the dried color layer with a #10 Meyer bar and oven dried for 2 minutes at 100°C and 2) a Matchprint™ II thermally sensitive polyacrylate copolymer adhesive was laminated onto the Matchprint™ II Commercial base and the dried color coat on polyvinylalcohol was laminated onto the base/adhesive substrate.

For the samples evaluated with adhesives, the samples were laminated to a 10" x 12" (25 x 30 cm) piece of Matchprint™ Commercial base and the polyester cover sheet was removed. The samples were then exposed using an UGRA scale target for about 30 seconds with a 5KW Diazo bulb after a one minute vacuum drawdown. The samples were processed with a modified MR 467 processor at 65 inches/min. (265 cm/min) with a developer temperature of 27°C. The developer formulation was 1% potassium carbonate, 1% potassium bicarbonate and 1% Surfynol™ GA surfactant (Air Products) in water. The samples were processed until an open non-imaged background was achieved. The higher the number of passes through the processor necessary to cleanout the background, the poorer was the developability of the system. Table 5 summarizes the data on millbase particle size and transparency, color coating transparency and the number of passes needed to obtain a clean background after exposure.

Generally, the coating made with the SAMP/EPON 1001/0.15 SA NEt₃/0.5 DEA oligomer were non-tacky, while those made with the HHA oligomer were tacky. Table 5 illustrates many important trends. Both Butvar™ and acid modified Butvar™ millbases have transparencies greater than 2.0 and particle sizes 0.5 µm or less. The Scripset™ 540 and Carboset™ 525 millbases have transparencies of 1.27 and 1.92 respectively and particle sizes of 1.32 and 0.94 microns respectively. The transparency of the Butvar™ and acid modified Butvar™ coating solutions are greater than 2.0, while the Scripset™ and Carboset™ 525 coating solutions have transparencies of 1.94 or less. Developability using the transferred adhesive (Matchprint™ II) was easier than that for the solution cast adhesive, and the HHA oligomer gave greater developability than the SAMP/EPON 1001 based oligomer. The unmodified Butvar™ resins developed very slowly while the acid modified Butvar™ resins allowed developability similar to the Carboset™ 525 and Scripset™ 540. In summary then, the acid modified Butvar™ resins gave smaller particle size and more transparent millbases than Carboset™ 525 and Scripset™ 540, while conferring comparable developability to the color coatings.

### Example 1

A 1 liter 3-necked roundbottom equipped with overhead stirrer was charged with 100g (0.308 equivalents, 325 hydroxyl equivalent weight, corrected for water) Butvar™ B-76 polyvinyl butyral, 24.02g (0.24 equivalents) succinic anhydride, 1.24g (1% by weight of solids) benzyltriethylammonium chloride and 300g methyl ethyl ketone and heated at reflux for approximately 16 hours. At the end of this time infrared analysis of the reaction showed no diminishment of the anhydride peaks at 1858 and 1789 cm⁻¹. Then 24.1g (0.24 equivalents) triethylamine was added to the reaction. After approximately 20 hours more of reaction at reflux, infrared analysis showed no anhydride bands and the reaction was stopped.

### Example 2

A 2 liter 3-necked roundbottom equipped with overhead stirrer was charged with 300g (1.351 hydroxyl equivalents, 222 hydroxyl equivalent weight, corrected for water) Butvar™ B-98, 90g (0.90 equivalents) succinic anhydride, 90g (0.90 equivalents) triethylamine and 900 g methyl ethyl ketone and heated at 77°C (batch). At the start of the reaction, an infrared spectrum of the reaction mixture was taken showing strong anhydride bands at 1858 and 1780 cm⁻¹. At 2.5 and 4.5 hours infrared spectra of the reaction showed no anhydride peaks. After running a total of 6 hours, the reaction was bottled.

### Examples 3-10

This is an example of a positive acting photosensitive composition comprising an O-quinone diazide compound, one or more alkali soluble resins and, as desired, one or more dyes or pigments as colorants. The O-quinone diazides, as known in the art, become alkali soluble upon activation by radiation allowing exposed areas to be washed away in developers with pH's between 8.5 and 13.5

In all constructions, the mill bases were 3 parts pigment and 2 parts acidified polyvinyl butyral (Butvar™ B-98). The Joncryl™ resins (Johnson Wax) are acrylic acid/styrene copolymers.

| Example No. | Resin No. (Joncryl #) | Acid No. |
|---|---|---|
| 3 | 67 | 190 |
| 4 | 566 | 105 |
| 5 | 587 | * |
| 6 | 611 | 55 |
| 7 | 678 | 200 |
| 8 | 680 | 215 |
| 9 | 682 | 235 |
| 10 | 683 | 160 |

| | | |
|---|---|---|
| * mostly hydroxyl functional | | |

All examples were developed mechanically with a brush at 152 cm/min, 26°C with an aqueous developer comprising 1% potassium carbonate, 1.0% potassium bicarbonate, and 0.1% surfactant. Exposure time was 10-15 seconds with a 5 KW ultraviolet radiation lamp. All compositions developed nicely.

The media comprised a sample layer on a polyester film substrate, the layer comprising 5.0 parts of 10% by weight mill base, 0.18 parts, 2,1,4-naphthoquinone diazide triester of trihydroxybenzophenone, 0.23 parts Joncryl™ resin, and 4.0 parts methyl ethyl ketone.

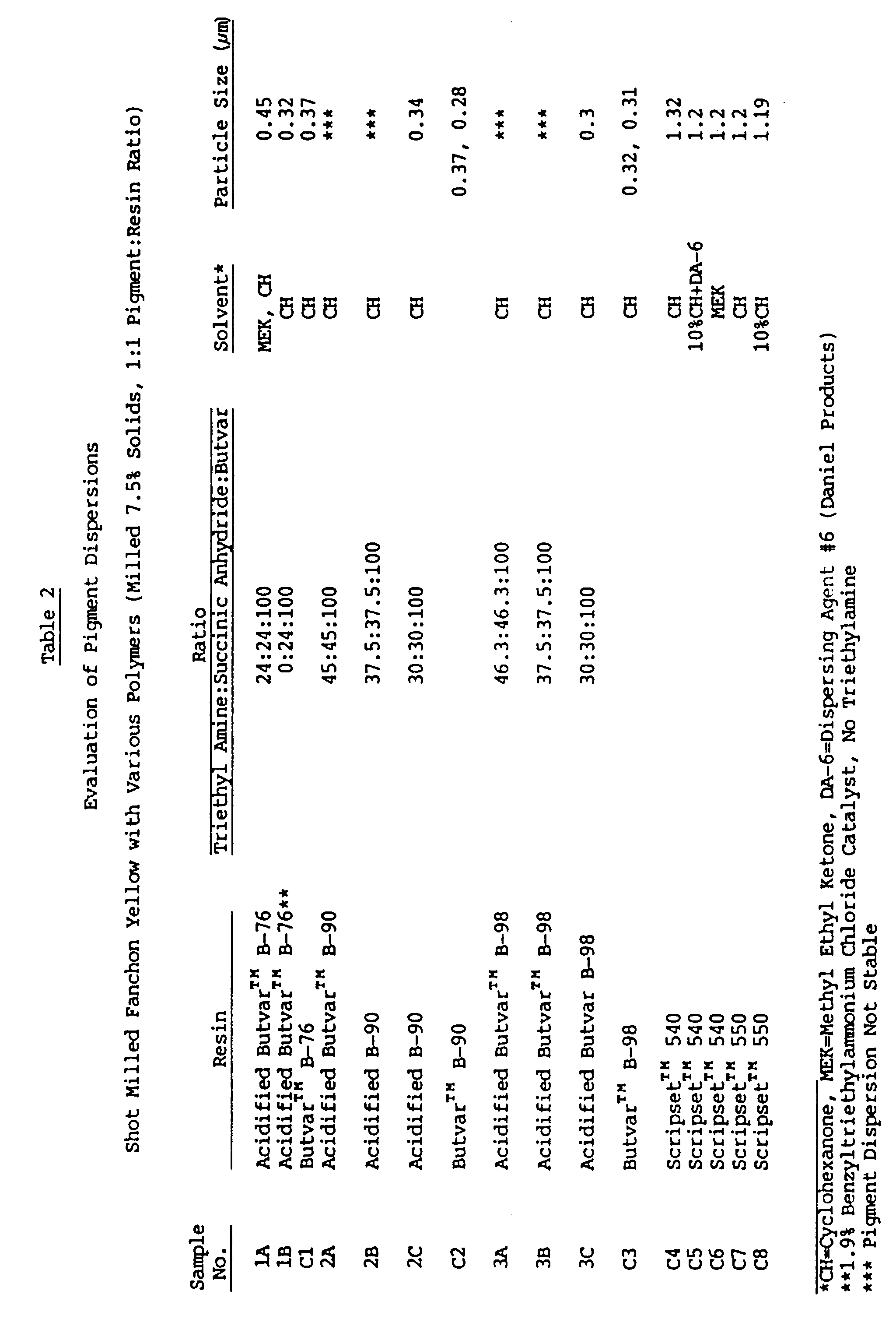

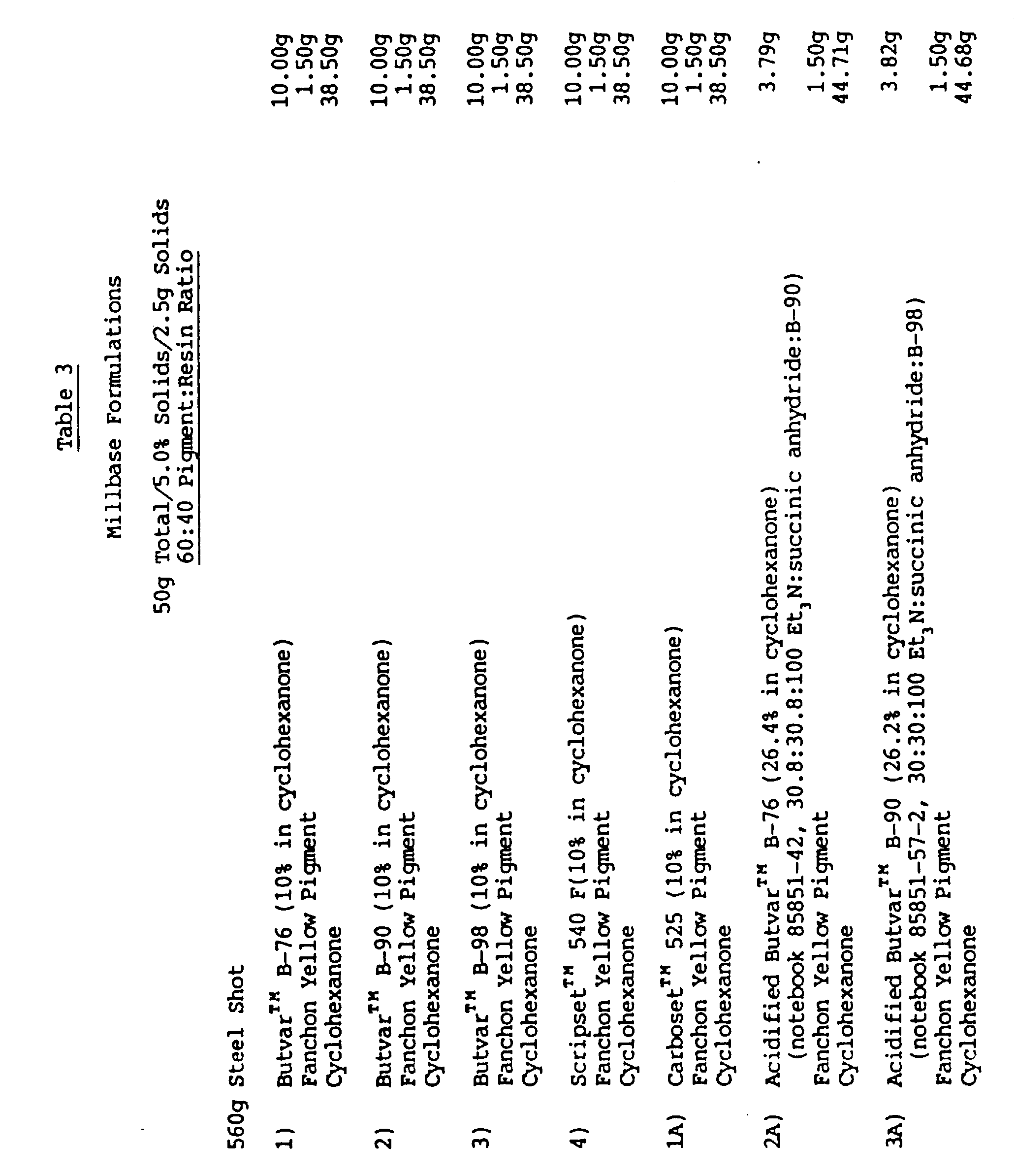

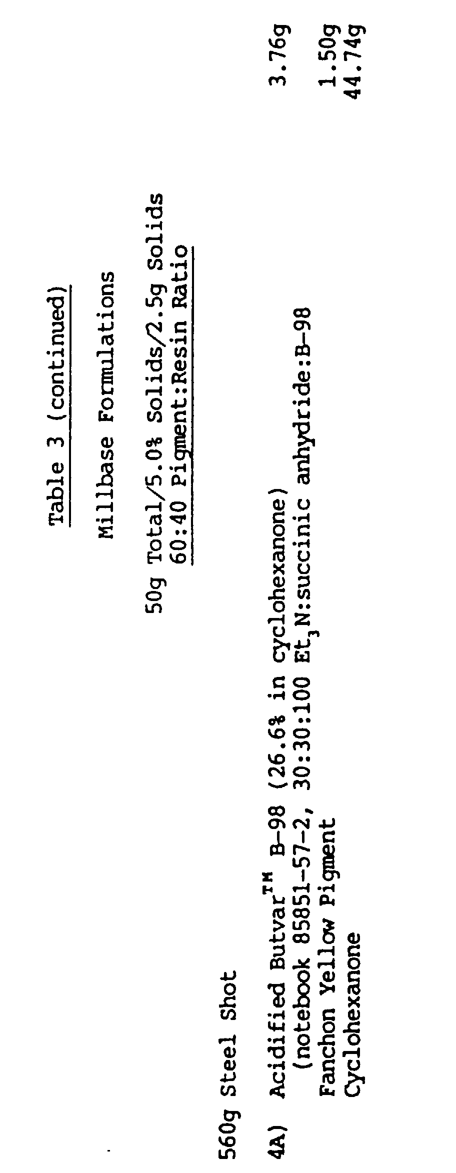

**Table 4**

| Coating Solution Formulations | |
|---|---|
| 5.000g | Shot Millbases 1-4A (5% in cyclohexanone) |
| 0.908g | Oligomer [SAMP 1001, PP6444-3] (65% in MEK) |
| 1.000g | Irgacure™ 907 (10% in cyclohexanone) |
| 0.600g | Quanticure™ ITX (10% in cyclohexanone) |
| Total Percent Solids = 13.3% | |
| | |
| 5.000g | Shot Millbases 1-4A (5% in cyclohexanone) |
| 0.670g | HHA [notebook 75588-41] (88% in butyl acetate) |
| 1.000g | Irgacure™ 907 (10% in cyclohexanone) |
| 0.600g | Quanticure™ ITX (10% in cyclohexanone) |
| 0.238g | Cyclohexanone |
| Total Percent Solids = 13.3% | |

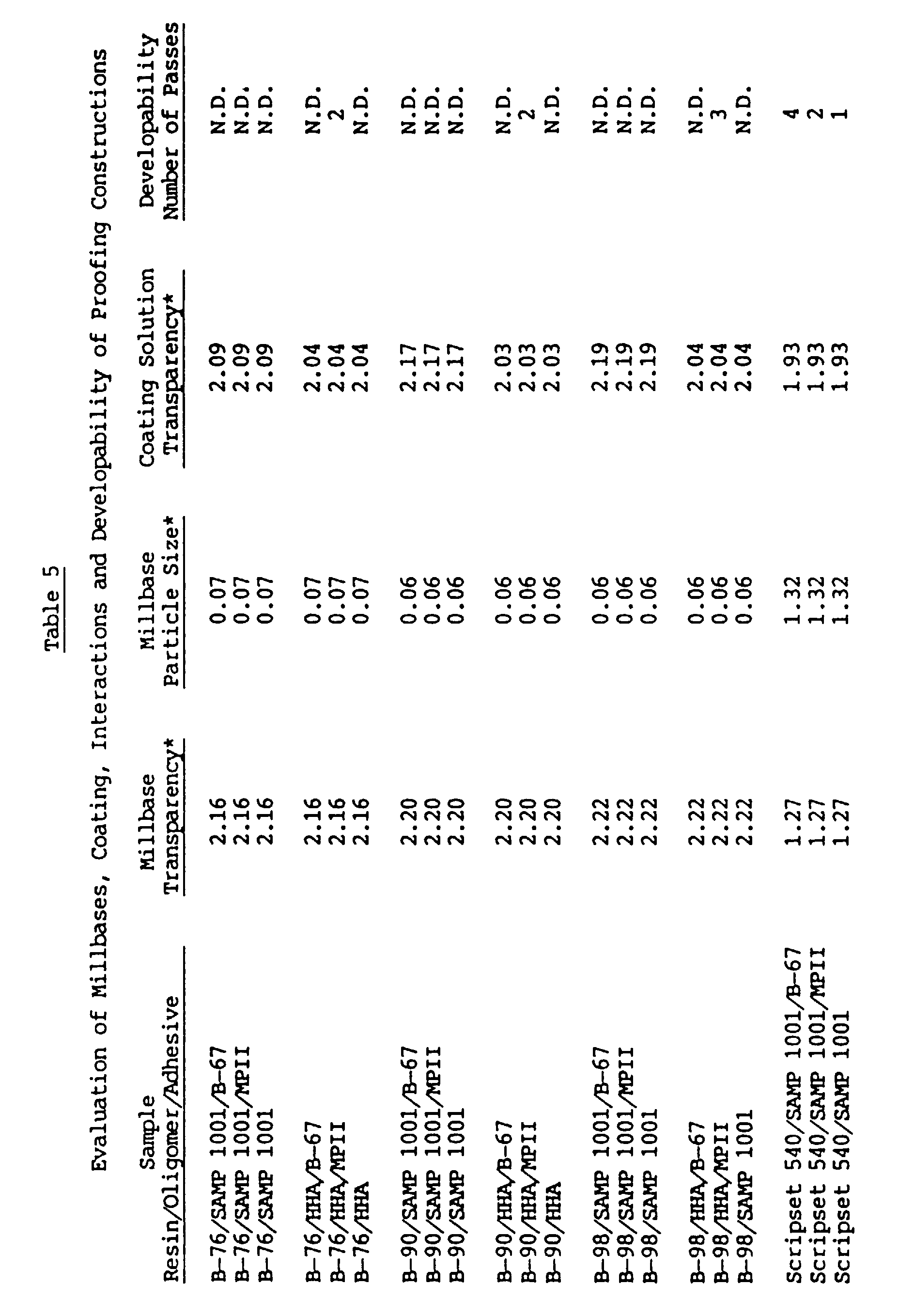

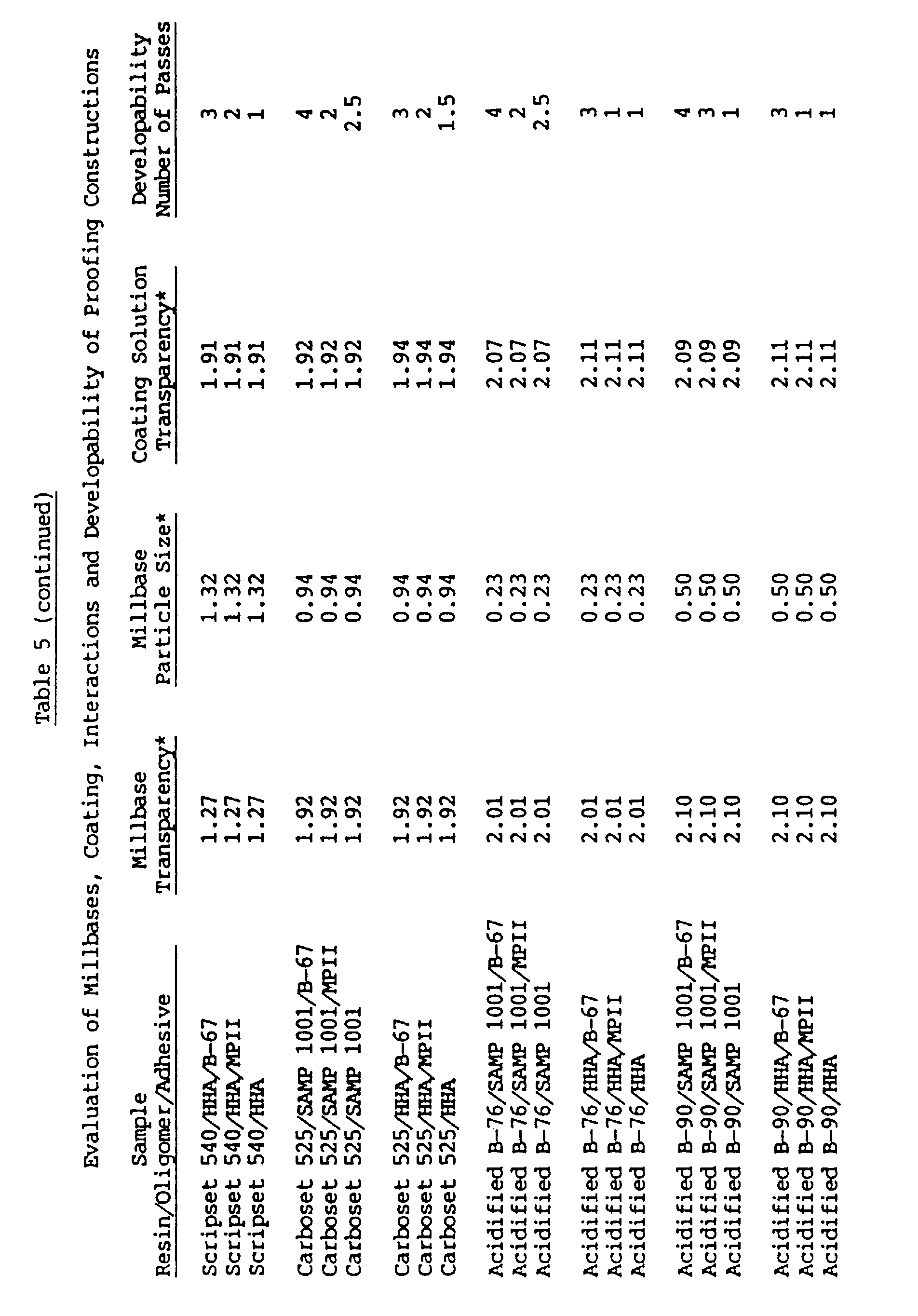

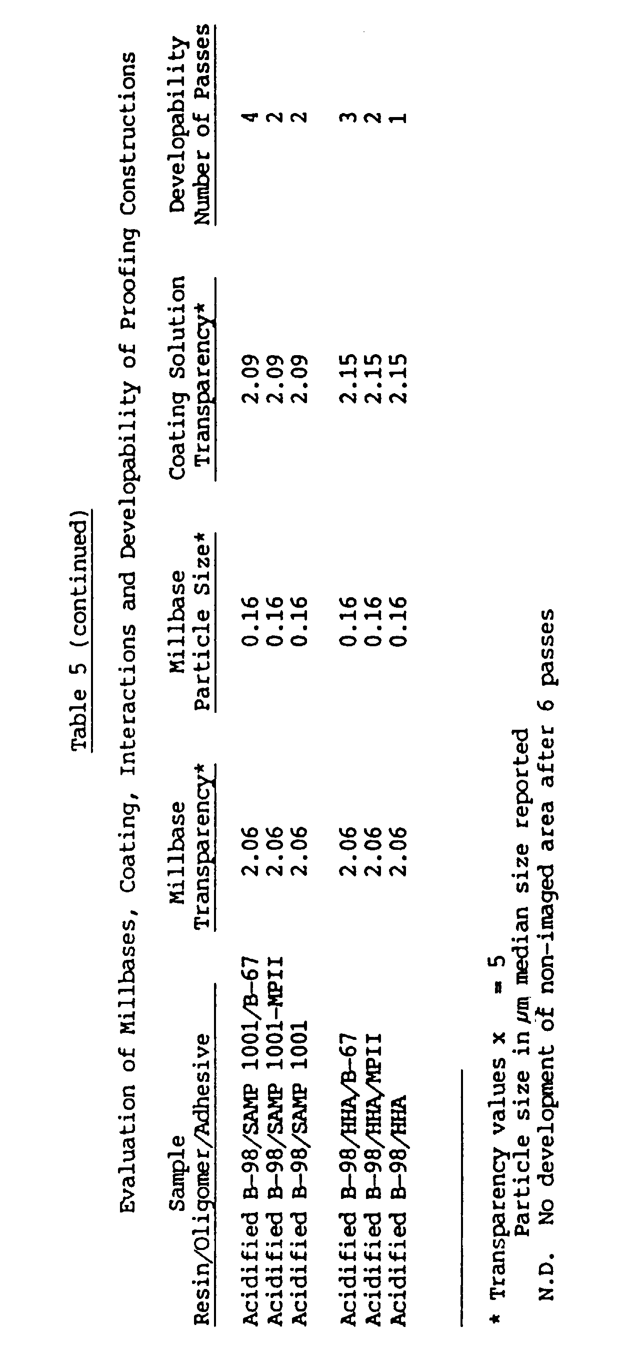

## Claims

1. An aqueous developable imageable medium free of diazonium polymer comprising a photosensitive layer having a dispersibility in aqueous alkaline solution which alters when activated by irradiation, said medium further comprising a pigment dispersion in a resin binder comprising a polyvinylacetal resin having at least a portion of the hydroxyl groups of said resin replaced with organic acid residues, said dispersion being within said photosensitive layer or in an adjacent layer, and the pigment to resin binder ratio being in the range of 0.6 to 5.0.

2. The media of claim 1 wherein said photosensitive layer is a negative acting photopolymerizable layer having free radical polymerizable ethylenically unsaturated materials therein, and wherein said organic acid residues form ester groups.

3. The media of claim 2 wherein said pigment dispersion is within said photosensitive layer.

4. The media of claims 2 or 3 wherein said photosensitive layer comprises an ethylenically unsaturated material and a photoinitiator.

5. The media of claim 4 wherein said ethylenically unsaturated material comprises an acrylic or methacrylic polymerizable material.

6. The media of any preceding claim wherein said polyvinylacetal comprises polyvinylbutyral.

7. The media of claim 4 wherein said polyvinylacetal resin has been reacted with carboxylic acid anhydrides to replace at least a portion of said hydroxyl groups.

8. The media of any preceding claim wherein said polyvinylacetal resin has been reacted with carboxylic acid anhydrides to replace at least a portion of said hydroxyl groups, and a diazo oxide is present in said binder resin.

9. The media of claims 1, 2 or 3 comprising a positive coating imaging system in which said pigment dispersion is in a binder resin layer adjacent to a layer comprising diazo oxide in a binder resin.

## Patentansprüche

1. Wässrig entwicklungsfähiges Mittel zum Bildaufzeichnen, frei von Diazonium-Polymer, umfassend eine photoempfindliche Schicht mit Dispergierfähigkeit in wässriger alkalischer Lösung, die sich bei Bestrahlung verändert, welches Mittel ferner eine Pigment-Dispersion in einem Harz-Bindemittel mit einem Polyvinylacetal-Harz umfaßt, wobei mindestens ein Teil der Hydroxyl-Gruppen des Harzes ersetzt sind durch organische Säurereste, wobei sich die Dispersion im Inneren der photoempfindlichen Schicht befindet oder in einer angrenzenden Schicht und wobei das Pigment/Harz-Verhältnis im Bereich von 0,6 ... 5,0 liegt.

2. Mittel nach Anspruch 1, bei welchem die photoempfindliche Schicht eine negativ wirkende, photopolymerisierbare Schicht ist, die darin radikalisch polymerisierbare, ethylenisch ungesättigte Substanzen aufweist, und worin die organischen Säurereste Ester-Gruppen bilden.

3. Mittel nach Anspruch 2, bei welchem sich die Pigment-Dispersion in der photoempfindlichen Schicht befindet.

4. Mittel nach Anspruch 2 oder 3, bei welchem die photoempfindliche Schicht eine ethylenisch ungesättigte Substanz und einen Photoinitiator umfaßt.

5. Mittel nach Anspruch 4, bei welchem die ethylenisch ungesättigte Substanz ein acrylisches oder methacrylisches Material umfaßt.

6. Mittel nach einem der vorgenannte Ansprüche, bei welchem das Polyvinylacetal ein Polyvinylbutyral umfaßt.

7. Mittel nach Anspruch 4, bei welchem das Polyvinylacetal-Harz mit Carbonsäureanhydriden umgesetzt wurde, um mindestens einen Teil der Hydroxyl-Gruppen zu ersetzen.

8. Mittel nach einem der vorgenannte Ansprüche, bei welchem das Polyvinylacetal-Harz mit Carbonsäureanhydriden umgesetzt wurde, um mindestens einen Teil der Hydroxyl-Gruppen zu ersetzen, und bei welchem ein Diazo-Oxid in dem Bindemittelharz vorliegt.

9. Mittel nach Anspruch 1, 2 oder 3, umfassend ein positives Beschichtungssystem zum Bildaufzeichnen, worin sich die Pigment-Dispersion in einer Bindemittelharz-Schicht angrenzend an einer Schicht befindet, die Diazo-Oxid in einem Bindemittelharz aufweist.

## Revendications

1. Support d'enregistrement d'images développable en milieu aqueux, dépourvu de polymère diazonium, comprenant une couche photosensible ayant une dispersibilité en solution aqueuse alcaline qui se modifie lorsqu'elle est activée par éclairement, ledit support comprenant, en outre, une dispersion de pigment dans un liant résineux comprenant une résine de polyvinylacétal dont au moins une partie des groupes hydroxyle sont remplacés par des résidus d'acides organiques, ladite dispersion se trouvant à l'intérieur de ladite couche photosensible ou dans une couche adjacente, et le rapport du pigment au liant résineux étant dans la gamme de 0,6 à 5,0.

2. Support selon la revendication 1, dans lequel ladite couche photosensible est une couche photopolymérisable à action négative contenant des substances à insaturation éthylénique polymérisables par polymérisation radicalaire, et dans lequel lesdits résidus d'acides organiques forment des groupes ester.

3. Support selon la revendication 2, dans lequel ladite dispersion de pigment se trouve à l'intérieur de ladite couche photosensible.

4. Support selon la revendication 2 ou 3, dans lequel ladite couche photosensible comprend une substance à insaturation éthylénique et un photo-initiateur.

5. Support selon la revendication 4, dans lequel ladite substance à insaturation éthylénique comprend une substance acrylique ou méthacrylique polymérisable.

6. Support selon l'une quelconque des revendications précédentes, dans lequel ledit polyvinylacétal comprend le polyvinylbutyral.

7. Support selon la revendication 4, dans lequel ladite résine de polyvinylacétal a été mise à réagir avec des anhydrides d'acides carboxyliques pour remplacer au moins une partie desdits groupes hydroxyle.

8. Support selon l'une quelconque des revendications précédentes, dans lequel ladite résine de polyvinylacétal a été mise à réagir avec des anhydrides d'acides carboxyliques pour remplacer au moins une partie desdits groupes hydroxyle, et un oxyde diazoïque est présent dans ladite résine liante.

9. Support selon les revendications 1, 2 ou 3, comprenant un système d'enregistrement d'images à couche positive, dans lequel ladite dispersion de pigment est une couche de résine liante adjacente à une couche comprenant l'oxyde diazoïque dans une résine liante.
